(19) Europäisches Patentamt

European Patent Office

Office européen des brevets

(11) Veröffentlichungsnummer: **0 284 915 B1**

(12) **EUROPÄISCHE PATENTSCHRIFT**

(45) Veröffentlichungstag der Patentschrift: **28.10.92**

(21) Anmeldenummer: **88104309.5**

(22) Anmeldetag: **18.03.88**

(51) Int. Cl.⁵: **H05K 7/14**, H05K 5/00

(54) **Elektrische Schalteinheit.**

(30) Priorität: **31.03.87 DE 8704572 U**

(43) Veröffentlichungstag der Anmeldung:
**05.10.88 Patentblatt 88/40**

(45) Bekanntmachung des Hinweises auf die
Patenterteilung:
**28.10.92 Patentblatt 92/44**

(84) Benannte Vertragsstaaten:
**AT BE CH DE ES FR GB GR IT LI LU NL SE**

(56) Entgegenhaltungen:
**DE-A- 2 041 805**
**DE-U- 1 964 258**
**DE-U- 8 432 684**
**DE-U- 8 519 474**

(73) Patentinhaber: **SEW-EURODRIVE GMBH & CO.**
**Ernst-Blickle-Strasse 42**
**W-7520 Bruchsal(DE)**

(72) Erfinder: **Schmidt, Josef**
**Dettenheimer Weg 2**
**W-7523 Graben-Neudorf 2(DE)**
Erfinder: **Trümpler, Walter**
**Kleinbachstrasse 21**
**W-7500 Karlsruhe 41(DE)**

(74) Vertreter: **Lempert, Jost, Dr.rer.nat. et al**
**Patentanwälte Dr. Ing. Hans Lichti Dipl.-Ing.**
**Heiner Lichti Dipl.-Phys. Dr.rer.nat. Jost Lem-**
**pert Postfach 410760**
**W-7500 Karlsruhe 41(DE)**

## Beschreibung

Die Erfindung betrifft eine elektrische Schalteinheit, wie Gleichrichtereinheit für eine elektromagnetische Motorbremse oder dergleichen, mit einem Unterteil und mindestens einem Deckteil, wobei ein Deckteil und eine elektronische Bauteile tragende Platine zu eines in das Unterteil einsetzbaren Einsetzeinheit verbunden sind und das Deckteil über den Bauteilen auf der mit diesen versehenen Seite der Platine angeordnet ist.

Derartige Schalteinheiten sind in unterschiedlicher Ausgestaltung bekannt. Es wurde beispielsweise vorgeschlagen, die elektrischen Bauteile in einem Gehäuseunterteil mit einem Gewindeansatz auszubilden, wobei die Einsatzöffnung mit einem Deckel verschlossen ist. Das Gehäuseunterteil kann beispielsweise durch ein Reduzierstück gebildet sein, wobei der Deckel aufgeschraubt ist. Eine solche Einheit kann an einem herkömmlichen Kabelklemmkasten durch mit Innengewinde versehene Kabeldurchführungen angeschraubt werden, wobei die Anschlüsse der Einheit durch den mit einem Außengewinde versehenen Gewindeansatz hindurchgeführt sind. Die DE-A-2 041 805 beschreibt eine Deckplatte für Gehäuse mit einschiebbaren Leiterplatten. Die Deckplatte ist mit einer Leiterplatte verbunden, welche alle Kontroll- und/oder Einstellgeräte der Deckplatte, z.B. Glühlampen, Meßinstrumente, Potentiometer und Schalter, trägt. Dabei ist vorgesehen, daß die Deckplatte entsprechende Bohrungen und Durchbrüche für die Achsen der Potentiometer, Drehschalter, Lampen usw. aufweist. Durch die Verbindung der Deckplatte mit einer Leiterplatte soll eine Vereinfachung des Anschlusses der Leiterplatte an weitere Stromkreise über ein Verdrahtungsgerüst mittels Kontaktleisten erleichtert werden.

Demgegenüber liegt der Erfindung die Aufgabe zugrunde, eine derartige elektrische Schalteinheit in kompakter Weise zum Anschluß externer Verbindungsleitungen auszubilden, die auch unabhängig von separaten Klemmkästen eingesetzt werden kann.

Erfindungsgemäß wird die genannte Aufgabe bei einer elektrischen Schalteinheit, wie Gleichrichtereinheit für eine elektromagnetische Motorbremse oder dergleichen, mit einem Unterteil und mindestens einem Deckteil, wobei ein Deckteil und eine elektronische Bauteile tragende Platine zu einer in das Unterteil einsetzbaren Einsetzeinheit verbunden sind und das Deckteil über den Bauteilen auf der mit diesen versehenen Seite der Platine angeordnet ist, dadurch gelöst, daß das Deckteil als Anschlußleiste mit Anschlußeinrichtungen ausgebildet ist, und daß die Anschlußeinrichtungen elektrisch mit Leiterbahnen der Platine verbunden sind. Während überlicherweise Anschlußeinrichtungen, wie Klemmen, fest im Gehäuseunterteil ausgebildet sind, oder aber bei Ausbildung an einem Deckteil die Anschlüsse üblicherweise an der der Seite, auf der die Bauteile angeordnet sind, abgewandten Rückseite oder möglicherweise an Stirnseiten vorgesehen sind, sieht die Erfindung vor, daß Bauelemente und Deckteil auf der gleichen Seite der Platine angeordnet sind, wobei das Deckteil zumindestens einen Teil der Bauelemente in hinreichendem Abstand überbrückt, so daß die Bauelemente nicht beeinträchtigt werden. Die Verbindung und die Anordnung von Platine und Deckteil mit Abstand kann insbesondere dadurch erreicht werden, daß das Deckteil mit der Platine über von Anschlußeinrichtungen ausgehenden sich weit vom Deckteil forterstreckende Kontaktfüße verbunden sind. Zusätzlich kann vorgesehen sein, daß das Deckteil auf die Platine zu gerichtete Abstandhalter aufweist. Bei dieser Ausbildung wird das Deckteil mit hinreichendem Abstand zur Platine gehalten, bevor die Kontaktfüße an der Platine endgültig durch Verlöten festgelegt sind. Ein bequemer Zusammenbau der aufeinander abgestimmten Teile wird insbesondere dadurch erreicht, daß Unterteil und Einsetzteil in Seitenwänden aufeinander abgestimmte Führungs-Nuten und -Federn aufweisen. Hierdurch können Unterteil und Deckteil relativ zueinander beim Zusammensetzen geführt werden.

In weiterer bevorzugter Ausbildung ist vorgesehen, daß das mit der Platine verbundene Deckteil nur einen Teil der Einsetzöffnung des Unterteils abdeckt, während der restliche Teil der Öffnung durch ein separates Deckteil abgedeckt ist, wobei insbesondere die in das Unterteil eingesetzte, mit Bauelementen versehene und mit dem Deckteil verbundene Platine im Unterteil vergossen ist. Dadurch, daß das Deckteil nicht die gesamte Öffnung des Unterteils abdeckt, können Platine und Bauelemente in das Unterteil eingesetzt werden und nachträglich ein dichtes Vergießen der Bauelemente durchgeführt werden, was bei einer vorherigen Abdeckung der gesamten Öffnung des Deckteils bei der erfindungsgemäßen Ausgestaltung der Einsetzeinheit nicht möglich wäre. Weitere Ausbildungen sehen vor, daß über das Unterteil eine zusätzliche brückenartige Kontaktleiste mit elektrischen Anschlußeinrichtungen gesetzt ist und daß die in das Unterteil eingesetzte, mit Bauelementen versehene und mit dem Deckteil verbundene Platine im Unterteil vergossen ist.

Durch die Erdindung wird eine kompakte Schalteinheit geschaffen, die aus bausatzartig aufeinander abgestimmten Einzelteilen besteht, die bequem und leicht miteinander zur gesamten Einheit verbunden werden können. Dies gilt sowohl für die Verwendung von Platine und dieser zugeordnetem Deckteil als auch für die Verbindung der Deckteile mit dem Unterteil sowie die Anordnung des gegebenenfalls zusätzlich vorgesehenen brückenartigen der gegebenenfalls vorgesehenen brückenartigen Kontaktleiste.

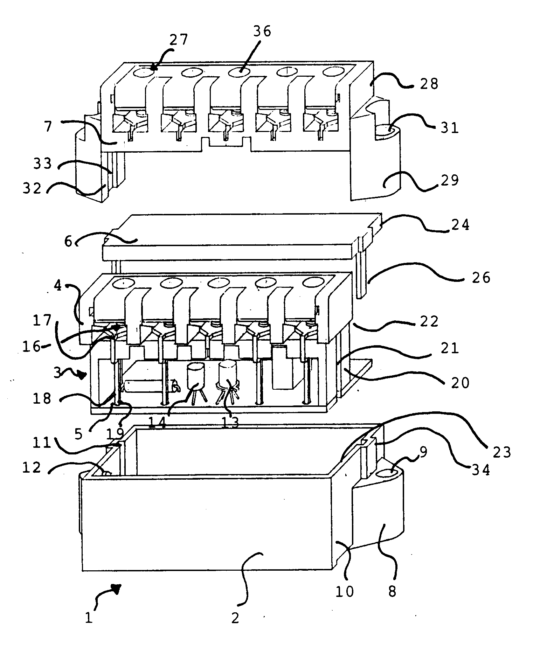

Weitere Vorteile und Merkmale der Erfindung ergeben sich aus den Ansprüchen und aus der nachfolgenden Beschreibung, in der ein bevorzugtes Ausführungsbeispiel unter Bezugnahme auf die Zeichnung im einzelnen erläutert ist. Dabei zeigt die einzige Figur:
das Ausführungsbeispiel in perspektivischer Explosionsdarstellung.

Die erfindungsgemäße Schalteinheit 1 weist ein Unterteil 2, eine Einsetzeinheit 3 mit einem ersten Deckteil 4 und einer Platine 5, im dargestellten Ausführungsbeispiel hier ein weiteres separates Deckteil 6 sowie eine Kontaktleiste 7 auf. Wenn die zusätzliche Kontaktleiste 7 in der Umgebung, in der die Schalteinheit eingesetzt wird, nicht benötigt wird, so kann sie auch entfallen. Wenn im Einsatzbereich der erfindungsgemäßen Schalteinheit 1 eine derartige zusätzliche Kontaktleiste 7 regelmäßig eingesetzt wird, so kann sie auch integriert und einstückig mit dem weiteren Deckteil 6 ausgebildet sein, so daß dieses als separates Teil entfallen kann. Grundsätzlich kann auch nur ein sich über die gesamte Öffnung des Unterteils 2 erstreckendes Deckteil 4 vorgesehen sein; doch weist die dargestellte Ausgestaltung mit zwei Deckteilen 4, 6 Vorteile auf, die im weiteren erläutert werden.

Das Unterteil weist außenseitig Befestigungsansätze 8 mit Durchbrüchen 9 zur Befestigung der Schalteinheit mittels Schrauben auf. An gegenüberliegenden inneren Seitenwänden weist das Unterteil 2 Nuten 11 bzw. Federn 12 auf, die mit entsprechenden komplementären Ausbildungen an den Deckteilen 4, 6 zum Plazieren darselben zusammenwirken.

Die Platine 5 weist eine Fläche auf, die der Grundfläche des Innenraums des Unterteils 2 entspricht, so daß sie in dieses einsetzbar ist. Auf der dem Deckteil 4 zugekehrten Oberseite der Platine 5 sind die elektrischen Bauelemente 13, 14 angeordnet, von denen in der Zeichnung nur einige beispielhaft dargestellt sind.

Das Deckteil 4 ist als Anschlußleiste ausgebildet und weist in Vertiefungen Anschlußklemmen 16 zum Anschluß von Verbindungsleitungen auf. Die Anschlußklemmen 16 sind mit einer unteren Kontaktplatte 17 mit Schraubgewinde versehen, gegen die durch eine eingeschraubte Schraube eine obere Kontaktplatte angedrückt wird, so daß zwischen den beiden Kontaktplatten das blanke Ende einer Anschlußleitung eingeklemmt wird. Mit der unteren Kontaktplatte 17 ist einstückig ein Kontaktfuß 18 ausgebildet, der zur Unterseite des Deckteils 4 geführt ist und sich von dort senkrecht über eine beträchtliche Strecke forterstreckt, bis er mit seinem Ende 19 durch einen entsprechenden Kontaktdurchbruch der Platine 5 hindurchtritt, wo er mit dieser bzw. einer auf dieser aufgebrachten Leiterbahn verlötet ist.

Im dargestellten Ausführungsbeispiel weist das Deckteil 4 insgesamt fünf Anschlußpunkte auf, wobei von vier Anschlußpunkten entsprechende Kontaktfüße 18 zur Platine 5 geführt sind, während der mittlere abgeschnitten ist und nicht in Kontakt mit den Bauteilen 13, 14 auf der Platine steht. Er dient lediglich als Klemme zur Verbindung zweier Leitungen.

Das Deckteil 4 weist weiterhin im dargestellten Ausführungsbeispiel an seinen Stirnseiten sich von ihm zur Platine hin erstreckende Abstandhalter 20 auf, die den Klemmenbereich der Deckleiste 4 in einem ihrer Höhe entsprechenden Abstand zur Platine 5, insbesondere bei der Fertigung, halten, während nach Verlöten der Kontaktfüße 18 an der Platine 5 auch hierdurch der notwendige Abstand aufrechterhalten wird. Die Abstandhalter 19 weisen in ihrer Seitenwand im dargestellten Ausführungsbeispiel jeweils eine Nut 21 auf, die mit der Feder 12 des Unterteils 2 zum paßgenauen Einsetzen der Einsetzeinheit 3 in das Unterteil 2 zusammenwirken. Die Deckteile 4 weisen an ihren Stirnseiten seitlich über die Abstandhalter 20 hinausragende Absätze 22 auf, mit denen sie auf einer Oberkante 23 der entsprechenden Seitenwände 10 des Unterteils 2 aufsitzen.

Das Deckteil 6 ist im wesentlichen eben ausgebildet und weist an seinen Stirnseiten 24 sich senkrecht von seiner Hauptfläche erstreckende Ansätze 26 auf, mit denen es in die Nut 11 des Unterteils 2 zwecks genauer Positionierung eingreift.

Die zusätzliche Kontaktleiste 7 ist hinsichtlich der Ausgestaltung ihrer Anschlüsse zum Anschluß von Leitungen ähnlich den entsprechenden Anschlüssen des Deckteils 4 ausgebildet. Auch sie weist fünf Stützpunkte 27 mit zwei Klemmplatten auf, die durch jeweils eine Schraube unter Zwischenlage des blanken Endes einer Verbindungsleitung verspannbar sind. Es kann hierdurch eine Standheizung oder dergleichen in sauberer Übersichtlicher Weise angeschlossen werden, was bisher durch freihängende Lüsterklemmen gemacht wurde. Die Kontaktleiste 7 überbrückt das Unterteil 2 und weist an ihren Stirnseiten 28 Befestigungsfüße 29 auf, die ähnlich den Befestigungsansätzen 8 den Unterteils 2 ausgebildet sind und ebenfalls einen Durchbruch 31 zur Aufnahme einer Schraube aufweisen. Auf ihrer Innenseite 32 weisen die Befestigungsansätze 29 jeweils eine Nut 33 auf, die mit einem auf der Außenseite der Seitenwand 10 des Unterteils 2 angeordneten Ansatz 34, der parallel zur Nut 11 verläuft, zusammenwirken, um die Kontaktleiste paßgenau am Unterteil 2 festzulegen, so daß der Durchbruch 31 mit dem Durchbruch 9 des Unterteils fluchtet.

Die Anschlußteile von Kontaktleiste 7 und Deckteil 4 sind durch eine Klemmleiste gesichert, die mit Rastnasen am Teil 4 bzw. 7 selbst festgelegt ist und die die Kontaktplatten 17 unter Freilassung jeweils einer Öffnung 36 zum Angreifen mittels eines Schraubenziehers an den Köpfen der Schrauben überdeckt.

Auf der Platine 5 werden zunächst die elektrischen Bauelemente aufgesetzt. Anschließend wird das Deckteil 4 aufgesetzt, wobei die Kontaktfüße 18, wie gesagt, durch entsprechende Druchbrüche der Platine hindurchgesteckt werden. Die Bauelemente und die Kontaktfüße 18 werden dann an ihren entsprechenden Durchsteckpunkten mit den Leiterbahnen der Platine verlötet.

Anschließend wird die Einsatzeinheit 3 in das Unterteil 2 eingesetzt. Dadurch, daß das Deckteil 4 beim dargestellten Ausführungsbeispiel nicht die gesamte Öffnung des Unterteils 2, sondern nur einen Teil derselben abdeckt, können die Bauelemente 13, 14 anschließend vergossen werden. Erst danach wird bei dieser Ausgestaltung das zweite Deckteil auf den bisher freigelassenen Teil der Öffnung des Unterteils 2 aufgesetzt und die Deckteile werden dicht mit dem Unterteil 2 verbunden, beispielsweise durch Verkleben am Umfangsrand, gegebenenfalls auch durch Verschweißen, wenn die Gehäusematerialien dies zulassen. Am mit der Schalteinheit zu versehenden Gerät wird, falls dies gewünscht wird, die Kontaktleiste im Bereich über dem Deckteil 6 auf das Unterteil 2 aufgesteckt und beide werden mittels Schrauben am entsprechenden Gerät befestigt.

**Patentansprüche**

1. Elektrische Schalteinheit, wie Gleichrichtereinheit für eine elektromagnetische Motorbremse oder dergleichen, mit einem Unterteil (2) und mindestens einem Deckteil (4), wobei ein Deckteil (4) und eine elektronische Bauteile tragende Platine (5) zu einer in das Unterteil einsetzbaren Einsetzeinheit verbunden sind und das Deckteil über den Bauteilen auf der mit diesen versehenen Seite der Platine angeordnet ist, dadurch gekennzeichnet, daß das Deckteil (4) als Anschlußleiste mit Anschlußeinrichtungen (16, 17) ausgebildet ist, und daß die Anschlußeinrichtungen (16, 17) elektrisch mit Leiterbahnen der Platine (5) verbunden sind.

2. Einheit nach Anspruch 1, dadurch gekennzeichnet, daß das Deckteil (4) mit der Platine (5) über von den Anschlußeinrichtungen (16, 17) ausgehenden, sich weit vom Deckteil (4) forterstreckenden Kontaktfüße (18) verbunden sind.

3. Einheit nach Anspruch 1 oder 2, dadurch gekennzeichnet, daß das Deckteil (4) auf die Platine (5) zu gerichtete Abstandhalter (20) aufweist.

4. Einheit nach einem der vorangehenden Ansprüche, dadurch gekennzeichnet, daß Unterteil (2) und Einsetzeinheit (3) in Seitenwänden aufeinander abgestimmte Führungs-Nuten und -Federn aufweisen.

5. Einheit nach einem der vorangehenden Ansprüche, dadurch gekennzeichnet, daß die Platine (5) nahezu auf dem Boden des Unterteils (2) aufsitzt und die Bauelemente (13, 14) sich nach oben erstrecken.

6. Einheit nach einem der vorangehenden Ansprüche, dadurch gekennzeichnet, daß das mit der Platine (5) verbundene Deckteil (4) nur einen Teil der Einsetzöffnung des Unterteils (2) abdeckt, während der restliche Teil der Öffnung durch ein separates Deckteil (6) abgedeckt ist.

7. Einheit nach Anspruch 6, dadurch gekennzeichnet, daß die in das Unterteil (2) eingesetzte, mit Bauelementen (13, 14) versehene und mit dem Deckteil (4) verbundene Platine (5) im Unterteil vergossen ist.

8. Schalteinheit nach einem der vorangehenden Ansprüche, dadurch gekennzeichnet, daß über das Unterteil (2) eine zusätzliche brückenartige Kontaktleiste (7) mit elektrischen Anschlußeinrichtungen gesetzt ist.

9. Einheit nach Anspruch 8, dadurch gekennzeichnet, daß die Kontaktleiste (7) gleichzeitig mit dem Unterteil (1) festlegbar ist.

10. Einheit nach einem der Ansprüche 1 bis 9, dadurch gekennzeichnet, daß die Deckteile (4, 6) als Leisten ausgebildet sind.

**Claims**

1. Electrical switching unit, such as a rectifier unit for an electromagnetic motor brake or the like, with a base (2) and at least one cover (4), a cover (4) and a printed circuit board (5) carrying electronic components are linked to form an insert unit insertable in the base and the cover is positioned above the components on the side of the circuit board provided with said components, characterized in that the cover (4) is constructed as a connector strip with connecting devices (16, 17) and that said connecting devices (16, 17) are electrically connected to the condutors of the circuit board (5).

2.  Unit according to claim 1, characterized in that the cover (4) with the circuit board (5) are connected to contact feet (18) emanating from the connecting devices (16, 17) and extending well away from the cover (4).

3.  Unit according to clams 1 or 2, characterized in that the cover (4) has spacers (20) directed towards the printed circuit hoard (5).

4.  Unit according to one of the preceding claims, characterized in that the base (2) and the insert unit (3) have in side walls guide grooves and tongues matched to one another.

5.  Unit according to one of the preceding claims, characterized in that the circuit hoard (5) almost rests on the bottom of the base (2) and the components (13, 14) extend upwards.

6.  Unit according to one of the preceding claims, characterized in that the cover (4) connected to the circuit board (5) only covers part of the insert opening of the base (2), whereas the remainder of the opening is covered by a separate cover (6).

7.  Unit according to claim 6, characterized in that the printed circuit board (5) inserted in the base (2), provided with components (13, 14) and linked to the cover (4) is moulded in the base.

8.  Switching unit according to one of the preceding claims, characterized in that over the base (2) is provided an additional bridge-like contact strip (7) with electrical connecting devices.

9.  Unit according to claim 8, characterized in that the contact strips (7) can also be fixed to the base (2).

10. Unit according to one of the claims 1 to 9, characterized in that the covers (4, 5) are constructed as strips.

**Revendications**

1.  Unité de commutation électrique, par exemple unité de redressement pour un frein moteur électromagnétique ou analogue, comprenant une partie inférieure (2) et au moins un élément de recouvrement (4), un élément de recouvrement (4) et une platine (5) portant des composants électroniques étant groupés en une unité insérable dans la partie inférieure et l'élément de recouvrement étant disposé au-dessus des composants du côté de la platine équipé desdits composants, **caractérisée en ce** que l'élément de recouvrement (4) est conformé en plaque à bornes avec des dispositifs de raccordement (16, 17), et que les dispositifs de raccordement (16, 17) sont reliés électriquement à des pistes conductives de la platine (5).

2.  Unité selon la revendication 1, caractérisée en ce que l'élément de recouvrement (4) est relié à la platine (5) par l'intermédiaire de pieds de contact (18) qui partent des dispositifs de raccordement (16, 17) et s'étendent loin de l'élément de recouvrement (4).

3.  Unité selon l'une des revendications 1 ou 2, caractérisée en ce que l'élément de recouvrement (4) comporte des écarteurs (20) orienrtés vers la platine (5).

4.  Unité selon l'une des revendications précédentes, caractérisée en ce que la partie inférieure (2) et l'unité d'insertion (3) présentent dans des parois latérales des rainures et languettes de guidage adaptées les unes aux autres.

5.  Unité selon l'une des revendications précédentes, caractérisée en ce que la platine (5) repose presque sur le fond de la partie inférieure (2) et que les composants (13, 14) s'étendent vers le haut.

6.  Unité selon l'une des revendications précédentes, caractérisée en ce que l'élément de recouvrement (4) relié à la platine (5) ne recouvre qu'une partie de l'ouverture d'insertion de la partie inférieure (2), tandis que le reste de l'ouverture est recouvert par un élément de recouvrement (6) séparé.

7.  Unité selon la revendication 6, caractérisée en ce que la platine (5) insérée dans la partie inférieure (2), équipée des composants (13, &4) et reliée à l'élément de recouvrement (4) est scellée dans la partie inférieure.

8.  Unité de commutation selon l'une des revendications précédentes, caractérisée en ce que la partie inférieure (2) est coiffée d'une réglette de contacts (7) supplémentaire en forme de pont munie de dispositifs de raccordement électriques.

9. Unité selon la revendication 8, caractérisée en ce que la réglette de contacts (7) peut être bloquée simultanément avec la partie inférieure (1).

10. Unité selon l'une des revendications 1 à 9, caractérisée en ce que les recouvrements (4, 6) sont formés comme des liteaux.